# EUROPEAN PATENT SPECIFICATION

(11) **EP 0 167 627 B1**
(45) Date of publication and mention of the grant of the patent: **11.08.1993**
(21) Application number: 85900195.0
(22) Date of filing: 19.12.1984
(51) Int. Cl.: H03M 13/00

(54) **METHOD AND APPARATUS FOR DECODING ERROR CORRECTION CODE**
VERFAHREN UND VORRICHTUNG ZUR DEKODIERUNG EINES FEHLERVERBESSERUNGSKODES
PROCEDE ET APPAREIL DE DECODAGE D'UN CODE DE CORRECTION D'ERREUR

(30) Priority: 20.12.1983 JP 240525/83; 23.12.1983 JP 198079/83 U
(43) Date of publication of application: 15.01.1986
(60) Divisional application: 90109867.3
(73) Proprietor: SONY CORPORATION, Tokyo 141 (JP)
(72) Inventor: OZAKI, Shinya Sony Corporation, Shinagawa-ku Tokyo 141 (JP); ODAKA, Kentaro Sony Corporation, Shinagawa-ku Tokyo 141 (JP); FUKAMI, Tadashi Sony Corporation, Shinagawa-ku Tokyo 141 (JP)
(74) Representative: Ayers, Martyn Lewis Stanley
(86) International application number: PCT/JP84/00603
(87) International publication number: WO 85/02958

(56) References cited:
- GB-A- 2 093 238
- GB-A- 2 107 496
- JP-A- 5 943 646
- JP-A-58 171 144
- JP-A-58 219 648
- US-A- 4 044 328
- US-A- 4 107 650
- US-A- 4 205 324
- IBM Technical Disclosure Bulletin, vol.17, no.2, July 1974, pages 473-475

## Description

### TECHNICAL FIELD

This invention relates to a method and an apparatus for decoding error correction code.

### BACKGROUND ART

Product code are well known such that information symbols are arranged in two-dimensional form, error correction codes are encoded for each Row and column of the two-dimensional arrangement so that each information symbol is included in two error correction code series. In decoding the product code, the error correction code is decoded for each column and error correction code can be decoded for each row by employing the decode information. The decode information is called a pointer.

In the conventional methods, since each information symbol is associated with a pointer, it is required that the total number of pointers is at least equal to the number of information symbols.

Further, in the case where erasure correction is made by employing the pointers, since the pointers are read out from a pointer memory and the error value is calculated for every row, there exists a problem in that the number of processing steps such as memory accesses, calculations and so on inevitably increases.

On the other hand, in the case where complicated codes such as BCH codes are employed as error correction codes, since the operations for obtaining error values become inevitably complicated, there exists a problem in that a great number of program steps are required in the case where the calculations are implemented by hardware.

IBM Technical Disclosure Bulletin, Vol. 17, No. 2, July 1974, pages 473-475, on which the precharacterising portions of appended claims 1 and 2 are based, discloses an error correction system for taped data in which error pointers from column decoding are used in error correction of rows of the data. Of the three states which the error pointers may indicate, one is "no error" and another is "uncorrectable errors".

EP-A2-0096109 (Tokyo Shibaura Denki K.K.) is part of the state of the art by virtue of Article 54(3) E.P.C. and discloses a decoding method using a single Reed-Solomon-Code.

GB 2107496A discloses an error flag decoder in which the storage required for error flags can be reduced by use of a read address counter and frame read counter set with a particular offset and in which error flags can be stored in parity bits for a preceding frame.

US-A-4044329 discloses a coder/decoder which interleaves two dimensional data several times, adding parity bits between each stage.

An object of this invention is to provide a method and an apparatus for decoding error correction codes which can reduce the number of pointers required in decoding as well as reducing the number of memory regions for the pointers and the number of times the pointers need to be read and written to.

Another object of this invention is to provide a method and an apparatus for decoding error correction code which can markedly reduce the number of processing steps in dependence upon the fact that the pointers with respect to each row are the same.

Still another object of this invention is to provide an apparatus for decoding error correction codes which can reduce the number of calculating steps in an erasure correction.

A further object of this invention is to provide a method for decoding error correction codes which can obtain error values in decoding having a simple construction and a small number of processing steps.

According to a first aspect of the present invention there is provided a method for decoding error correction code in which respective first error correction codes of (n₁, k₁), where n₁ denotes the code length, are encoded for every k₁ information symbols arranged in respective columns of a two dimensional arrangement of (k₁ X k₂) and respective second error correction codes of (n₂, k₂), where n₂ denotes the code length, are encoded for every k₂ information symbols arranged in respective rows of the two dimensional arrangement, the method comprising the steps of:
receiving at least the respective first error correction codes;
decoding the first error correction codes to thereby detect errors in the respective columns of the two dimensional arrangement and correct those errors which are correctable;
generating respective first pointers subsequent to error correction as a result of the first error correction codes;
decoding the second error correction codes for the respective rows of the two dimensional arrangement and to thereby correct up to a predetermined maximum number of errors which are correctable; and
outputting the information symbols; characterised by
each of said first pointers indicating for its corresponding column either
(a) no error or the number of corrected errors is within a predetermined number or
(b) the number of corrected errors is over the predetermined number or errors cannot be corrected by the first error correction codes
   storing the respective first pointers in memory means having at least n₂ bits;
   generating respective second pointers for each row indicating for that row which of the following conditions c, d or e applies:
(c) no error is detected or error correction is possible by the second error correction codes
(d) error correction cannot be executed by the second error correction codes but pointers are of high reliability for that row
(e) error correction cannot be executed by the second error correcting codes and the first pointers are of low reliability for that row
   storing the respective second pointers in memory means having at least 2k₁ bits; and
   referring to the stored first and second pointers to manifest an indication of the reliability of the respective information symbols in response to the status of the respective first and second pointers in the respective columns and rows corresponding to the respective information symbols.

The invention also provides an apparatus for decoding error correction code in which respective first error correction codes of (n₁, k₁) (wherein n₁ denotes the code length) are encoded for every k₁ information symbols arranged in respective columns of a two dimensional arrangement of (k₁ X k₂) and respective second error correction codes of (n₂, k₂) (where n₂ denotes the code length) are encoded for every k₂ information symbols arranged in respective rows of the two dimensional arrangement, the apparatus comprising:
receiving means for receiving at least the respective first error correction codes;
decoding means connected to said receiving means and for decoding the respective first error correction codes to thereby detect errors in the respective columns of the two dimensional arrangement and correct those errors which are correctable and for generating respective first pointers, subsequent to error correction as a result of the first error correction codes, decoding the second error correction codes for the respective rows of the two dimensional arrangement and to thereby correct up to a predetermined maximum number of errors which are correctable; and
output means connected to said decoding means and for deriving the information symbols; characterised in that each of said first pointers indicates for its corresponding columns either
(a) no error or the number of corrected errors is within a predetermined number or
(b) the number of corrected errors is over the predetermined number or errors cannot be corrected by the first error correction codes
   first memory means are connected to said decoding means and have a capacity of at least n₂ bits for storing the respective first pointers;
   said decoding means generating respective second pointers for each row indicating for that row which of the following conditions, c, d or e applies:
(c) no error is detected or error correction is possible by the second error correction codes
(d) error correction cannot be executed by the second error correction codes but the first pointers are of high reliability for that row
(e) error correction cannot be executed by the second error correction codes and the first pointers are of low reliability for that row
   second memory means connected to said decoding means and having a capacity of at least 2k₁ bits for storing the respective second pointers; and
   means connected to said first and second memory means and for manifesting an indication of the reliability of the respective information symbols in response to the status of the respective first and second pointers in the respective columns and rows corresponding to the respective information symbols.

It will be appreciated that the terms "row" and "column" are used for convenience in describing the two dimensional array and may be interchanged without altering the invention.

The respective second error correction codes may be decoded by implementing an erasure correction for each code series of the second error correction codes by employing the respective first pointers; and
the step of second decoding include a step of calculating error values of erasure symbols by an algebraic expression consisting of a first term to be a common value and a second term to be individually independent values with respect to the erasure error corrections of the respective second error correction codes and the step of calculating error values includes implementing a first calculation of the first term only once corresponding to each of the respective first pointers; storing the result of the first calculation of the first term; and implementing each of the calculations for obtaining error values corresponding to the respective second error correction codes by each of second calculations of the second term and by using the stored result of the first calculation. Correspondingly in the apparatus for decoding error correction code the decoding means may calculate in said second decoding error values of erasure symbols by an algebraic expression consisting of a first term to be a common value and a second term to be individually independent values with respect to the erasure error corrections of the respective second error correction codes and said decoding means implement a first calculation of the first term only once corresponding to each of the respective first pointers, stores the result of the first calculation of the first term and implement each of the calculations for obtaining error values corresponding to the respective second error correction codes by each of second calculations of the second term and by using the stored result of the first calculation.

Further, in the present invention, paying attention to the fact that in linear non-dualistic code having a root of 1, one of the syndromes is an addition of (mod. 2) of a received symbol series, the apparatus for decoding error correction code can store a syndrome in a syndrome register and form an error value with respect to a single symbol by subtracting other error values from a value stored in the syndrome register in correcting a plurality of erroneous symbols.

The invention will be further described by way of non-limitative example with reference to the accompanying drawings in which:-
Fig. 1 is a schematic block diagram of an encoder according to an embodiment of the present invention.
Fig. 2 is a schematic block diagram showing the operation of an embodiment of the present invention.
Fig. 3 is a schematic block diagram showing a decoder according to one embodiment of this invention.
Fig. 4 is a block diagram showing an error correcting decoder according to Figure 3.
Fig. 5 is a block diagram of a part of the error location and error value calculating circuit of Figure 4.
Fig. 6 is a block diagram showing a construction of a second embodiment for use with this invention.
Fig. 7 is a block diagram for the processing circuit of Fig. 6.

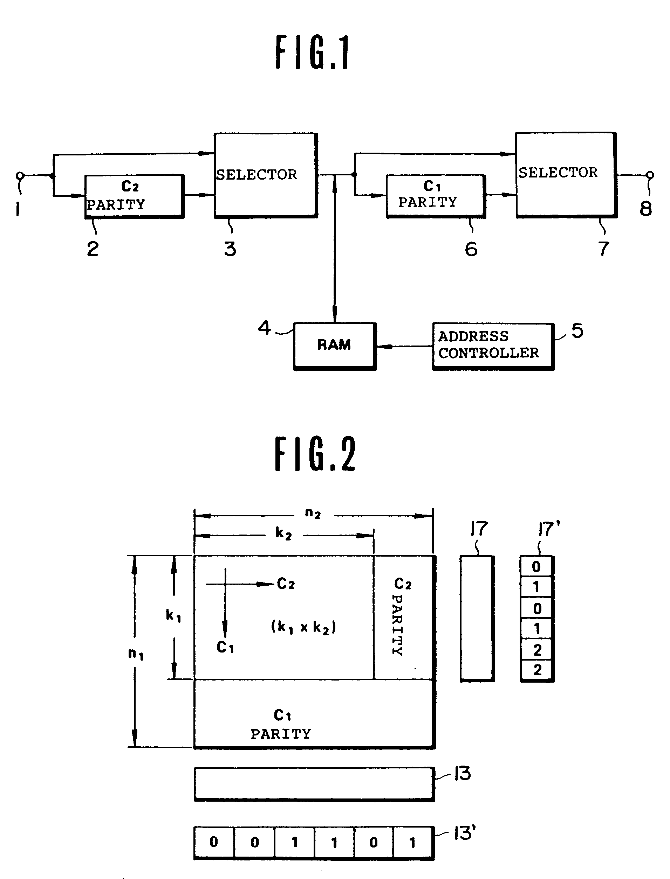

An embodiment of the present invention will be described, referring to the drawings. Fig. 1 shows a structure of an encoder for product code. The reference numeral 1 denotes an input terminal, the reference numeral 2 denotes a second error correction code C₂ parity generator. The input data from the input terminal 1 is supplied to the C₂ parity generator 2 and one input terminal of a selector 3. The C₂ parity data formed by the C₂ parity generator 2 is supplied to the other input terminal of the selector 3. The selector 3 repeats k₁ times the operations for selecting (n₂ - k₂) parity data after k₂ information symbols are selected. During this operation, the information symbols and the parity data are stored in a RAM (Random Access Memory) 4 in sequence under control of an address controller 5.

The data read out from the RAM 4 is supplied to a C₁ (the first error correction code) parity generator 6 and one input terminal of a selector 7 and the C₁ parity data formed by the C₁ parity generator 6 is supplied to the other input terminal of the selector 7. The selector 7 selects ((n₁ - k₁) x k₂) C₁ parity data after having selected (k₁ x n₂) symbols including the C₂ parity data. The digital data derived from an output terminal 8 of the selector 7 are transmitted or recorded on a magnetic tape (not shown) with a magnetic head, for instance. In this case, it is possible to write again the encoded output once into the RAM 4 and to read out it in different sequence for recording.

Fig. 2 shows configuration of code formed by the encoder as described above. The information symbols are arranged in two dimensions of (k₁ x k₂). The k₂ information symbols in every lateral direction, that is, in every row of the two-dimensional arrangement are subjected to the encoding process for the C₂ code. The k₁ information symbols in every vertical direction, that is, in every column are subjected to the encoding process for the C₁ code. The C₂ parity data is also encoded into the C₁ code. The C₁ code is, for instance, (n₁, k₁) Reed-Solomon code, by which it is possible to correct errors of up to (n₁ - k₁)/2 symbols.

The general method of decoding the Reed-Solomon code will be described.

The hamming distance of the (n, k) Reed-Solomon code where denotes the code length and k denotes the number of information symbols) on a Galois Field GF(2^{m}) can be expressed as $\text{(d = n - k + 1)}$ and the generator polynomial can be expressed as d-2 II (x + αⁱ). If the received words are (r₀, r₁, r₂, ..... , rₙ₋₁), i=0 the syndrome can be obtained by operating the following expression: 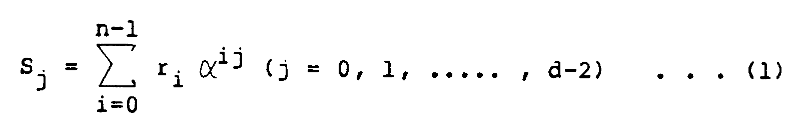
An error location polynomial σ(z) and an error evaluation polynomial ω(z) are obtained by employing the syndrome Sj. As to this method, Euclid's mutual division method, Berlekamp's method, Peterson's method and so on have been proposed.

By solving σ(z) = 0, the error location Xᵢ can be obtained. For this purpose, a Chien search is employed.

Then, the error value Yᵢ can be obtained on the basis of the error location Xᵢ and the error evaluation polynomial ω(z).

The above calculations in the decoding steps are explained with the error location as Xᵢ (i = 1, 2, ..... , e : e denotes the number of errors), and the error value as Yᵢ. Since the Reed-Solomon code is a linear code, the syndrome can be expressed as: 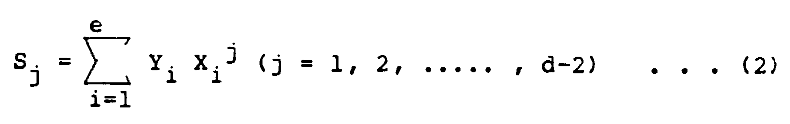
if the syndrome is expressed by a polynomial as: 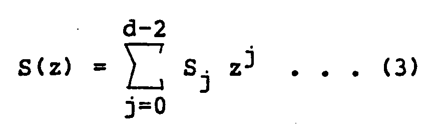
a following expression is obtained: 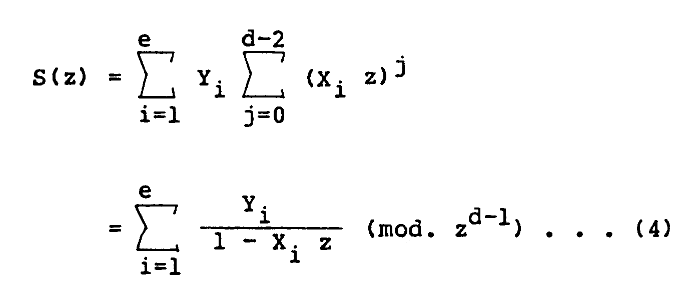
If the error location polynomial and the error evaluation polynomial are defined as 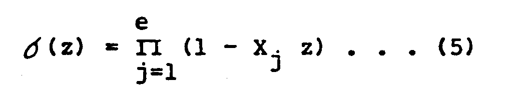
$\text{ω(z) = σ(z) S(z) (6)}$

then ω(z) can be expressed as 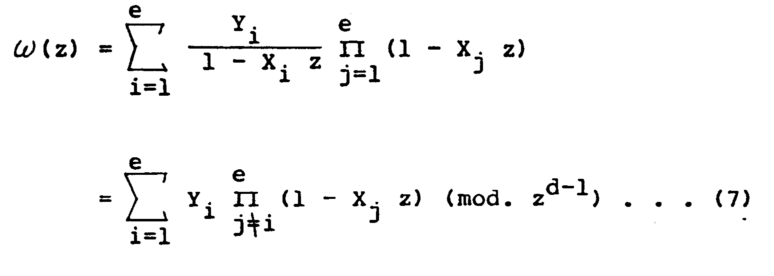
The error value Yᵢ can be obtained by substituting Xᵢ⁻¹ into z and by transforming the expression as follows: 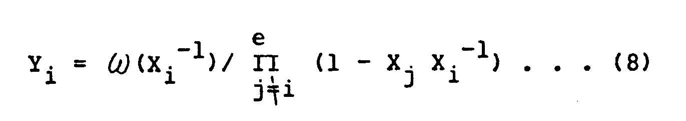
As an example, a (32, 24) Reed-solomon code having roots of α⁰ to α⁷ will be explained. Since this code is (d=8), it is possible to correct errors of up to 4 symbols. If the error locations of the 4 symbols are X₁ to X₄ and the error values are Y₁ to Y₄, the syndrome is obtained from following expression. 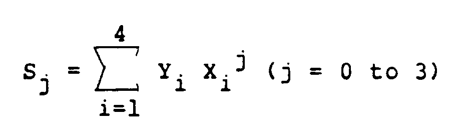
Namely, S₀ is as follows among 4 syndromes: 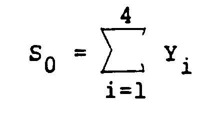
Once the error values Y₁, Y₂, Y₃ can be obtained, the remaining error value Y₄ is obtained as follows without implementing complicated calculations:

$\text{Y₄ = S₀ - Y₁ - Y₂ - Y₃}$

In codes on GF(2^{m}), a subtraction is equivalent to an addition of (mod. 2).

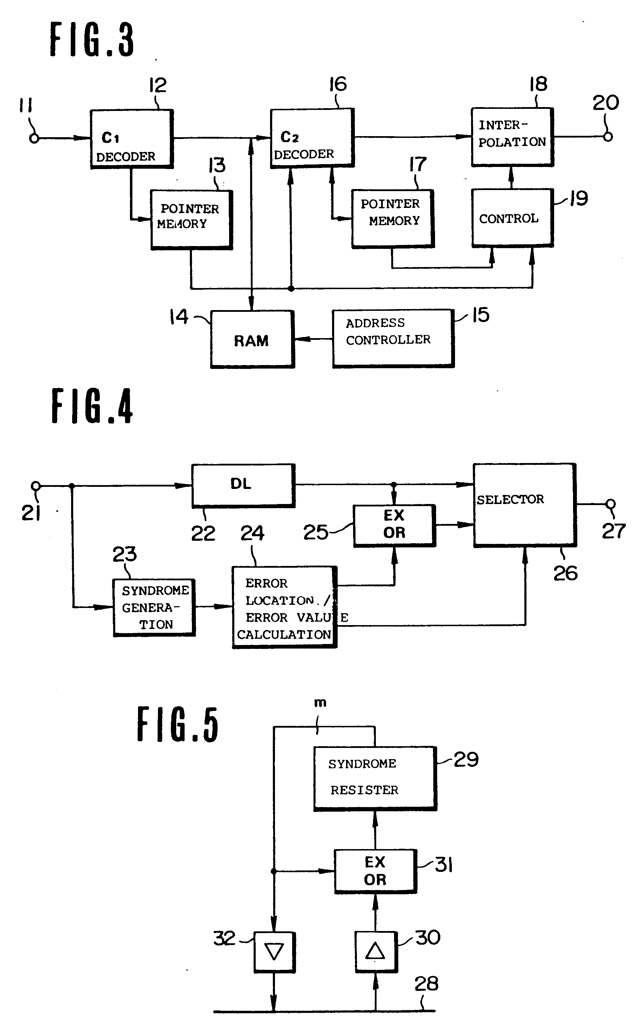

Fig. 3 shows a configuration of the decoder of this embodiment. In Fig. 3, the reproduced data is supplied from an input terminal designated by the reference numeral 11 and to a C₁ decoder 12. In the C₁ decoder 12, the decoding of the C₁ code is performed. All errors of up to $\text{(n₁ - k₁)/2}$ symbols are corrected in the C₁ decoding. In the case, however, where the number of errors in a single series of C₁ code is more than or equal to $\text{(n₁ - k₁)/2}$ , the C₁ pointer of this series is set to "1", the other pointers are set to "0". In Figs. 2 and 3, the reference numeral 13 denotes a pointer memory for storing the pointers of the C₁ code, which has n₂ bits. The output of the C₁ decoder 12 is stored temporarily in a RAM 14 in sequence under the control of an address controller 15.

The output read out from the RAM 14 is supplied to a C₂ decoder 16 to be subjected to the decoding of the C₂ code. The C₂ decoder 16 is supplied with the C₁ pointer from the pointer memory 13. Since the C₁ pointer is common to the all of K₁ series of C₂ code, it is possible to decode the C₂ code in accordance with the same procedure in each series. The C₂ decoder 16 corrects errors of up to $\text{(n₂ - k₂)/2}$ symbols and generates one of three kinds of pointers in the C₂ code which are stored in a pointer memory 17.

When error correction is performed by the C₂ decoder 16, the C₂ pointer with respect to the series is set to "0". When error correction can not be performed by the C₂ decoder 16 and the C₁ pointers are copied because of its high reliability, the C₂ pointer is set to "1". When error correction can not be performed by the C₂ decoder 16 and all symbols are determined to be erroneous symbols because of low reliability of the C₁ pointer, the C₂ pointers are set to "2". Therefore, the C₂ pointers have 2 bits and the pointer memory 17 has 2K₁ bits.

The pointer memories 13 and 17 are disposed separately from the RAM 14 for storing information symbols and parity data in decoding or may be disposed in common with the RAM 14 by using a part of the memory regions of RAM 14.

Without being limited to 1 bit, the C₁ pointer may have 2 bits or more. Further, it is possible to implement the error correction code processing of the C₂ code for the C₁ parity, while providing a C₂ pointer memory of (2n₁) bits.

The output data of the C₂ decoder 16 is supplied to an interpolation circuit 18 to conceal errors in the symbols which have not been corrected. The interpolation circuit 18 performs the mean value interpolation, for instance. The interpolation circuit 18 is controlled by a control circuit 19 which is supplied with the C₁ pointers and the C₂ pointers from the pointer memories 13 and 17. The output data of the interpolation circuit 18 is derived at an output terminal 20. The control circuit 19 determines by every information symbol whether interpolation is necessary on the basis of the c₁ pointer and c₂ pointer. In Fig. 2, There exist all the combinations of C₁ pointers designated as 13' and C₂ pointers designated as 17'.

When the C₂ pointer is "0" irrespective of the fact that the C₁ pointer is "0" or "1", the interpolation circuit 18 does not work. When the C₂ pointer is "1" and the C₁ pointer is "0", since it is determined that the information symbol has no error, no interpolation is done. When the C₂ pointer is "1" and the C₁ pointer is "1", since it is determined that it is an erroneous symbol, the interpolation operation is performed. Further when the C₂ pointer is "2" irrespective of the fact that the C₁ pointer is "0" or "1", since it is determined that it is an erroneous symbol, the interpolation operation is performed.

The reliability of the C₁ pointers is evaluated by the C₂ decoder. For instance, provided that up to 2 symbol errors can be corrected by the C₂ code, if correction by the C₂ code can not be performed in spite of the fact that only one C₁ pointer is "1", it is determined that the reliability of the C₁ pointer is low because the above is abnormal. Even if errors are not corrected by the C₂ code, it is possible to eliminate the necessity of interpolation by providing three kinds 0, 1, 2 of the C₂ pointers and by discriminating the copies of C₁ pointers from all errors.

In the above mentioned C₂ decoder 16, when the C₁ pointers are copied, erasure correction is made where the total value of the C₁ pointers is less than or equal to (n₂ - k₂) and when the erasure correction is made, the C₂ pointer is set to "0".

As described above, the decoding of the Reed-Solomon code is performed by calculation of the error location polynornial σ(z) and the error evaluation polynomial ω(z) in every row and by employing the syndrome obtained by n₂ symbols in each row. In the case of erasure correction, since the locations where the C₁ pointers are "1" are determined as the error locations, it is possible to obtain the error value Yᵢ from the error location Xᵢ and the error evaluation polynomial ω(z). That is to say, by substituting Xᵢ⁻¹ in place of z, Yᵢ can be obtained as follows, as in expression (8): 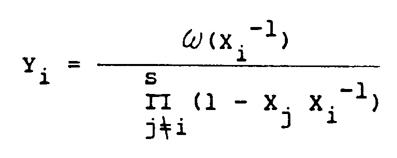
(where i = 1, 2, 3, ...s ; s denotes the number of symbols)
In the above expression, the term of denominator can be determined only by the error locations. For instance, provided that the error locations shown by the C₁ pointer are X₁, X₂, X₃, the terms of denominator of the expressions for obtaining the error values Y₁, Y₂, Y₃ are
Denominator of Y₁ : (1 - X₂ X₁⁻¹) (1 - X₃ X₁⁻¹)
Denominator of Y₂ : (1 - X₁ X₃⁻¹) (1 - X₂ X₃⁻¹)
Denominator of Y₃ : (1 - X₁ X₂⁻¹) (1 - X₃ X₂⁻¹)
Here, the pointers stored in the pointer memory 13 are the same in all the K₁ series of the C₂ code. Therfore, it is sufficient to implement the calculation of the term of the denominator in the above expression to obtain on error value only once with respect to the kᵢ series.

Fig. 4 shows the configuration of an error correcting decoder for use with the above mentioned C₁ and C₂ decodes. The received data is supplied to an input terminal designated by the reference numeral 21 and supplied to a delay circuit 22 and a syndrome generating circuit 23. The syndromes formed by the syndrome generating circuit 23 are supplied to an error location and error value calculating circuit 24. The error data from the error location and error value calculating circuit 24 are supplied to an exclusive OR gate 25 and added to the received data from the delay circuit 22 in (mod. 2). The received data from the delay circuit 22 and the error corrected data from the exclusive OR gate 25 are supplied to a selector 26. The selector 26 is controlled by the error location data. At the error locations, the output of the exclusive OR gate 25 is selected by the selector 26 to be derived at an output terminal 27 in place of the received data.

In the case of an audio PCM signal recording and reproducing apparatus, the reproduced data is once written in a RAM. By use of the data read out from the RAM, the syndrome is generated and on the basis of which the error locations and the error values are calculated. Fig. 5 shows a part of the error location and error value calculating circuit 24. In Fig. 5, the reference numeral 28 denotes a data bus through which data and syndrome and so on are transferred.

In Fig. 5, the reference numeral 29 denotes a syndrome register in which the syndrome S₀ is stored through the data bus 28, a bus buffer 30 and an exclusive OR gate 31. the syndrome S₀ has m bits in the case of Reed-Solomon code on GF(2^{m}). The syndrome S₀ from the syndrome register 29 is supplied to the exclusive OR gate 31 and the bus buffer 32.

When the syndrome S₀ is stored in the syndrome register 29, the obtained error values Y₁, Y₂, Y₃ are supplied to the exclusive OR gate 31 in sequence from the data bus 28 through the bus buffer 30. Therefore, the output of the exclusive OR gate 31 is (S₀ ⊕ Y₁), (S₀ ⊕ Y₁ ⊕ Y₂) and $\text{(S₀ ⊕ Y₁ ⊕ Y₂ ⊕ Y₃ = Y₄)}$ 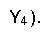 . The error value Y₄ is left in the syndrome register 29. The error value Y₄ is outputted to the data bus 28 through the bus buffer 32 to be employed for error correction.

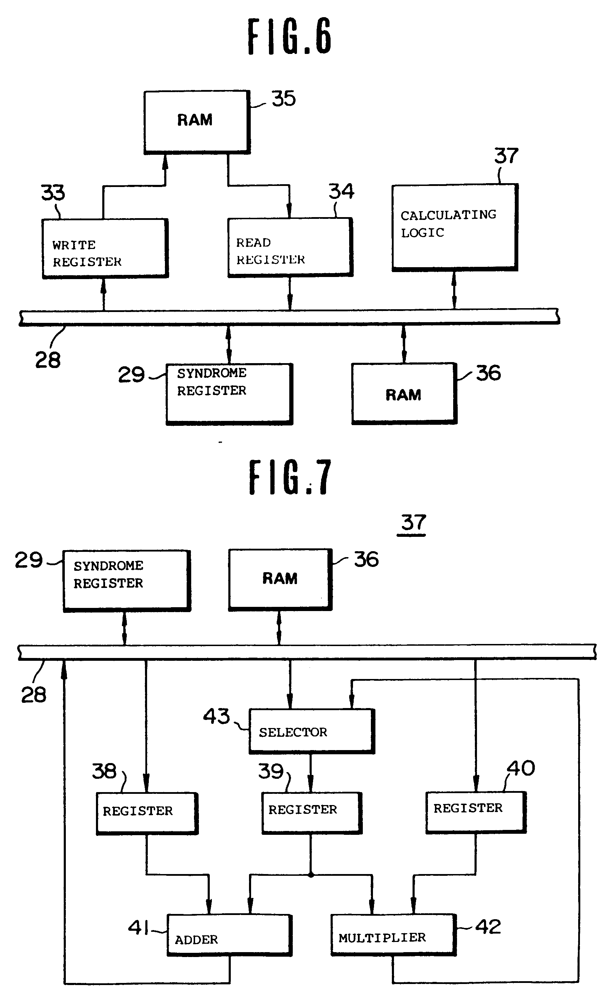

Fig. 6 shows another example of hardware for decoding in an erasure correction. A main RAM 35 is connected to the data bus 28 through a writing register 33 and a reading register 34. The syndrome register 29, a working RAM 36 and an operation logic circuit 37 are also provided to the data bus 28.

The erasure correction by Reed-Solomon code can be obtained by solving the following n-order linear simultaneous equations in the same way as in expression (2): 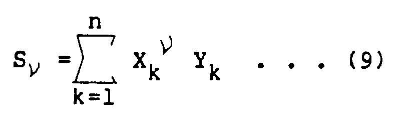
where,

$\text{ν = 0 to d - 2}$

- n: : Number of erasure
- Xₖ: : Location of kth
- S_{ν}: : Syndrome
- Yₖ: : Magnitude of error in the erasure of kth
- d: : Minimum distance of code
Here, n, Xₖ, S_{ν}, are known, Yₖ is unknown.

To solve the above equation, the following method has been conventionally adopted: if 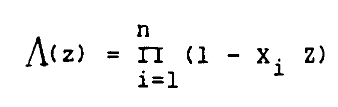
${\text{ω(z) = S(z) Λ(z) mod. z}}^{\text{d}} \text{⁻¹}$

Yᵢ can be obtained as in expression (8) as follows: 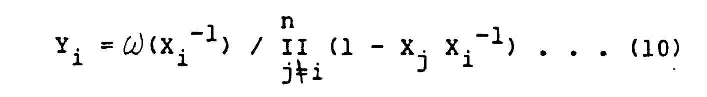
In this method, however, if the number of actual calculation steps is counted when d = 9 and n = 8, for instance.
(i) Expansion of Λ(z)
   Number of multiplications : 1 + 2 + ..... + 7 = 28
   Number of additions : 1 + 2 + ..... + 7 = 28
(ii) Previous calculations for obtaining the denominator of 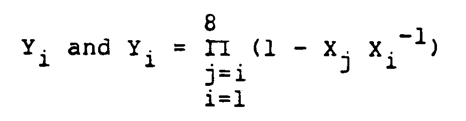 Number of reciprocals : 1 x 8 = 8
   Number of multiplications : (7 + 6) x 8 = 104
   Number of additions : 7 x 8 = 56
(iii) Calculations for obtaining ω(z) = S(z) Λ(z), mod. Z⁸
   Number of multiplications : 1 + 2 + ..... + 7 = 28
   Number of additions : 1 + 2 + ..... + 7 = 28
(iv) Calculations for obtaining ω(Xᵢ⁻¹)
   Number of reciprocals : 1 x 8 = 8
   Number of multiplications : 7 x 8 = 56
   Number of additions : 7 x 8 = 56
(v) Calculations for obtaining Yᵢ
   Number of division : 1 x 8 = 8
When these calculations each need one step, the number of steps is 408 in total.

In the circuit shown in Fig. 6, the roots of expression (9) are calculated by: 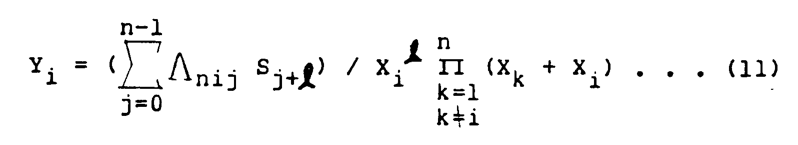
where
- Λₙᵢⱼ :: Coefficient of Z^{j} of 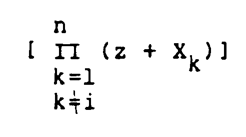
- ℓ :: Any integer more than or equal to 0 which satisfies ℓ ≦ d - n - 1
That is to say, in order to implement erasure correction, ℓ = 0, i = n are substituted into the expression (11) as follows: 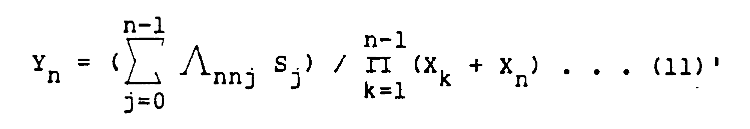
By this calculation, Yₙ is obtained and Yₙ 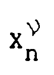
is added to each syndrome S as follows: 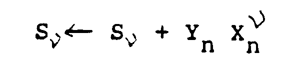
where
- ν =: 0 to n-2
Since the data at the location Xₙ are correct, the syndrome includes (n-1) erasures. Therefore, by reducing n by 1, Yₙ₋₁ can be obtained: 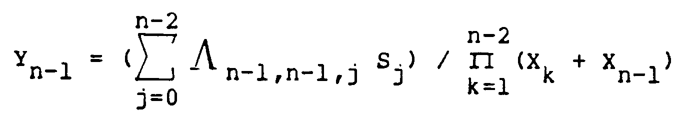
By this calculation, Yₙ₋₁ is obtained and 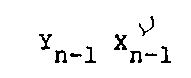
is added to each syndrome S as follows: 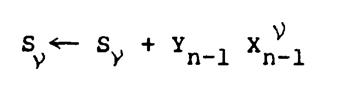
where
- ν =: 0 to n-3
By repeating the above, the last remaining erasure Y₁ can be obtained as
Y₁ = S₀
As explained above, an erasure correction can be implemented. In this case, the actual number of operation steps is counted in the same way as in the conventional method, provided that d = 9 and n = 8.
(i) Expansion of Λₙₙⱼ
   Number of multiplications : 1 + 2 + ..... + 6 = 21
   Number of additions : 1 + 2 + ..... + 6 = 21
(ii) Previous calculations for obtaining the denominator of Yₙ, 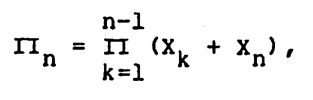 where it is sufficient to obtain only II₃ to II₈, since $\text{II₂ = X₁ + Y₂ = Λ₃₃₁}$ .
   Number of multiplications : 1 + 2 + ..... + 6 = 21
   Number of additions : 1 + 2 + ..... + 6 = 21
(iii) Calculations for obtaining the numerator of Yₙ
   Number of multiplications : 7 + 6 + ..... + 1 = 28
   Number of additions : 7 + 6 + ..... + 1 = 28
(iv) Calculations for obtaining Yₙ, since Y₁ = S₀
   Number of divisions : 7
(v) 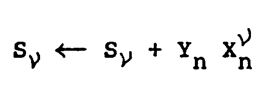 Number of multiplications : 6 + 5 + ..... + 1 = 21
   Number of additions : 7 + 6 + ..... + 1 = 28
The number of the above calculations steps is 202 in total.

Therefore, in the case of expression (11), it is possible to reduce the number of calculation steps to 50% of the conventional case in the expression (10).

Further, in the case where the above mentioned correction code is a product code, provided that 30 symbols are arranged in the vertical direction, 128 symbols are arranged in the lateral direction, the C₁ code is formed to the vertical direction, and the C₂ code is formed to the lateral direction, the erasure corresponds to the location of the C₁ pointers, and the location Xₖ (k=1 to n) is the same in all the C₂ code series. This means that it is possible to previously calculate Λₙₙⱼ and 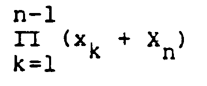
in expression (11)' without calculating these terms every C₂ decoding. That is to say, in this example, the above calculation is implemented only once while the C₂ decoding is performed 30 times.

Therefore, in the number of the above calculation steps, since the number of the calculations of (i) and (ii) is only once every 30 times of C₂ decoding, provided that the number of steps of (i) and (ii) is 90/30 = 3, the total number of steps is 115. compared with that in the conventional method, where the number of steps in (i) and (ii) is 224/3 = 74.7 and the total number of steps is 191.5, it is possible to reduce the number of steps by about 40%.

Accordingly, the method as above described has advantages such that it is possible to markedly reduce the number of calculation steps, processing time, hardware load for processing and so on as compared with the conventional method.

Additionaly, although the above calculations are performed by employing the operation logic 37, in the case where for example, 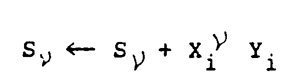
is obtained, an arrangement as shown in Fig. 7 is adopted. In Fig. 7, the reference numerals 38, 39, 40 denote registers, the reference numeral 41 denotes an adder, the reference numeral 42 denotes a multiplier, the reference numeral 43 denotes a selector, which are all built in the operation logic 37. In this circuit,
[1] S₀ is set to the register 38, Yᵢ is set to the register 39, and Xᵢ is set to the register 40, respectively through the data bus 28 from the syndrome register 29 and the working RAM 36 and so on. S₀ + Yᵢ is outputted from the adder 41 to the data bus 28.
[2] The content of the multiplier 42, Xᵢ Yᵢ, is fedback to the register 39 through the selector 43, and S₁ is set to the register 38 from the data bus 28. Therefore, S₁ + Xᵢ Yᵢ is outputted from the adder 41 to the data bus 28.
[3] Further, the content of the multiplier 42, Xᵢ² Yᵢ is fedback to the register 39 through the selector 43, and S₂ is set to the register 38 from the data bus 28. Therefore, S₂ + Xᵢ² Yᵢ is outputted from the adder 41 to the data bus 28.
[4] By repeating the above steps, S₃ + Xᵢ³ Yᵢ, S₄ + Xᵢ⁴ Yᵢ, .... are obtained sequentially and supplied to the syndrome register 29 through the data bus 28 so as to rewrite each value. The calculations are implemented as described above.

In the above explanation, although all of X₁ to Xₙ are assumed as erasures, in the case where X₁ to Xₙ₋₁ are erasures and Xₙ is an error, it is possible to correct the symbols. In this case, the number of unknown quantity are (n+1) of Y₁ to Yₙ and Xₙ. Xₙ can be obtained by using the above Λₙₙⱼ as follows: 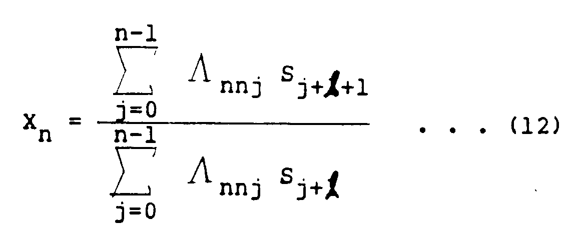
Therefore, the unknown quantity are Y₁ to Yₙ, and thereafter, this unknown quantity can be obtained in the same way as in the erasure correction.

For instance, in the case where d = 9 (6 erasures + 1 error) in product code,
[1] Check locations of the erasures X₁, X₂, ..... , X₆.
[2] Obtain and store Λₙₙⱼ, here 21 symbols in total of Λ₂₂₁ = X₁, Λ₃₃₁ = Λ₂₂₁ + X₂, Λ₃₃₂ = Λ₂₂₁ X₂, ....., Λ₇₇₁, ..... , Λ₇₇₆.
[3] Obtain and store 5 symbols in total of 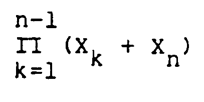 (n = 2 to 6).
The above processings are made once for each of the decoding cycles 30 times.
[4] Calculate syndromes S₀ to S₇.
[5] Obtain X₇ by an expression as follows: 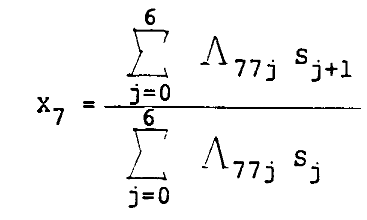
[6] Obtain Y₇ by the following expression and feedback the syndrome Y₇ X₇ :

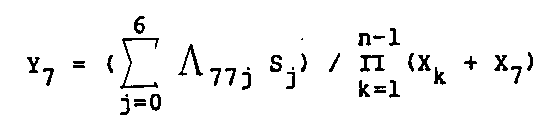

Thereafter, Y₆ to Y₁ (= S₀) are sequentially obtained.

Although a case where expression (11)' is used is shown in this example, the operation is the same if 1 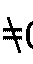 0.

As described above, it is possible to implement the correction of errors including erasures and one error. In this case, the number of calculation steps can be reduced as in the erasure correction described above.

The proof of the above expressions (11) and (12) will be described hereinafter:

[Lemma] If 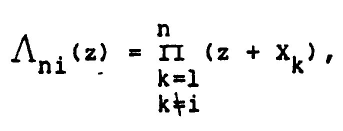
${\text{Λ}}_{\text{nij}} {\text{= [Λ}}_{\text{ni}} {\text{(z)]}}_{\text{j}}$

the following expression is cleary obtained: 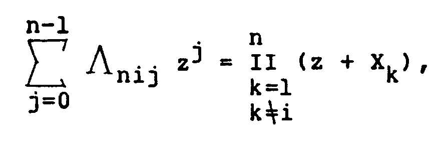
[Theorem 1] The n-order linear simultaneous equations: 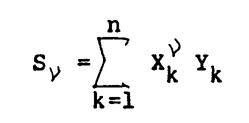
(ν = 0 to n-1 : Yᵢ is unknown quantity)
has the roots as: 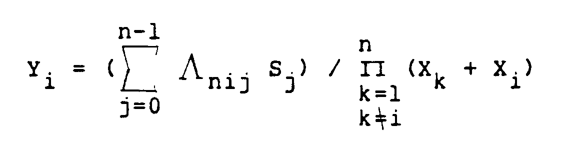
(Proof) 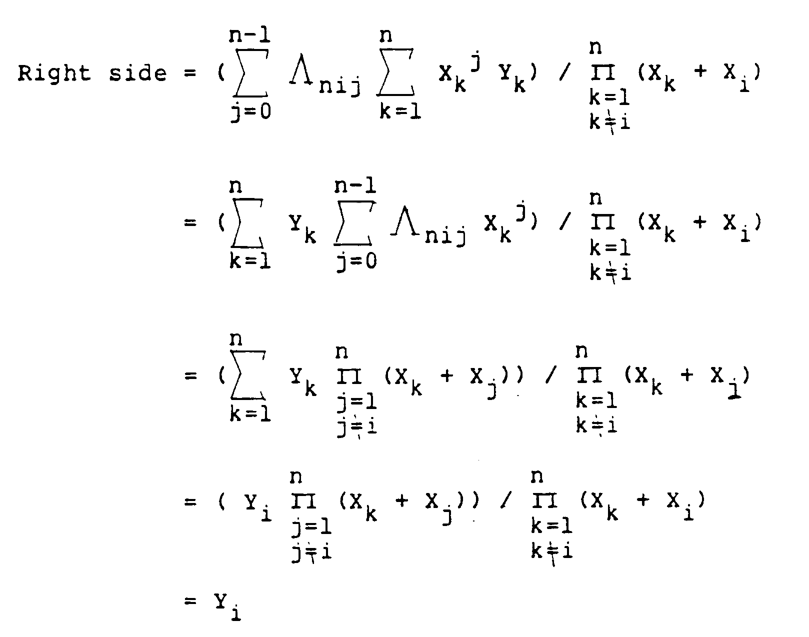
(Corollary 1) 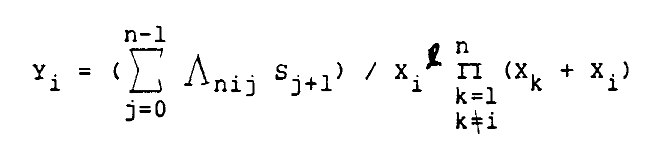
(ℓ ≧ 0)
(Proof) It is clearly proved by substituting into the above: 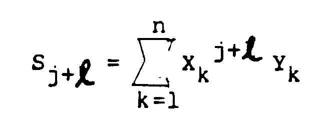
[Theorem 2] If Xᵢ to Xₙ₋₁ : Erasure and Xₙ is an error, 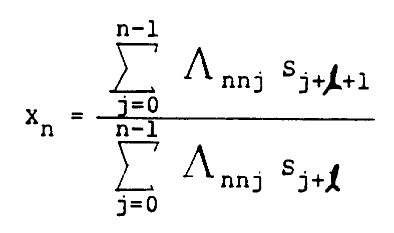
(Proof) From Corollary 1, 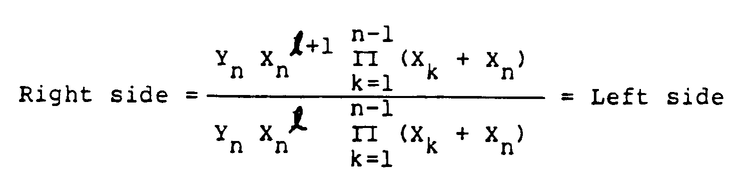
Therefore, it is understood from Theorem 1 that errors can be corrected in the erasure correction by use of any of S₁ to Sₙ, S₂ to Sₙ₊₁, ..... , S_{d-1-n} to S_{d-2} among the series of S₀ to Sₙ₋₁. That is, n continuous syndromes are necessary for n erasure corrections, the remaining syndromes are usable for checking, so that n ≦ d-1.

Further, to obtain Xₙ from theorem 2, a total of n+1 syndromes of S_{ℓ} to S_{n+ℓ} are necessary, so that n ≦ d-2. In this case, the number of erasures is n-1 ≦ d-3. The remaining syndromes can be used for checking as in the above case.

In the conventional method, the pointer areas are required for the total number of data (n₁, n₂) corresponding to the error correction code. According to the present invention, however it is possible to reduce the number of pointers to (n₂ + 2n₁) and further to reduce the capacity of the memory required in decoding Further, according to the present invention, it is possible to reduce the number of steps for writing or reading the pointers. Further, according to the present invention, in the case where the erasure correction in the C₂ decoding is implemented by the use of Pointers formed by the C₁ decoding, since the pattern of the pointers with respect to each series of C₂ code is common and a part of the operations to obtain error value becomes common, it is possible to implement the operation only once. Therefore it is possible to markedly reduce the number of processing steps in decoding and to realize a high-speed in decoding operation.

Furthermore, according to the present invention, without necessity to obtain the whole error values in accordance with a complicated error evaluation polynomial in obtaining a plurality of error values, it is possible to obtained one of the error values by a simple construction and to reduce the number of the processing steps.

Moreover, according to the present invention, it is possible to markedly reduce the number of calculation steps in erasure correction.

The present application describes matter described and claimed in co-pending applications No. 90109867.3 and No. 91200210.2 which were divided from this application.
- 12 :: C₁ decoder
- 16 :: C₂ decoder
- 13 and 17 :: pointer memory
- 18 :: interpolation circuit
- 25 and 31 ;: exclusive OR gate
- 28 :: data bus
- 29 :: syndrome register
- 35 :: main RAM
- 36 :: working RAM
- 37 ;: operation logic

## Claims

1. A method for decoding error correction code in which respective first error correction codes of (n₁, k₁), where n₁ denotes the code length, are encoded for every k₁ information symbols arranged in respective columns of a two dimensional arrangement of (k₁ X k₂) and respective second error correction codes of (n₂, k₂), where n₂ denotes the code length, are encoded for every k₂ information symbols arranged in respective rows of the two dimensional arrangement, the method comprising the steps of:
receiving (11) at least the respective first error correction codes;
decoding (12,16,14) the first error correction codes to thereby detect errors in the respective columns of the two dimensional arrangement and correct those errors which are correctable;
generating respective first pointers subsequent to error correction as a result of the first error correction codes;
decoding the second error correction codes for the respective rows of the two dimensional arrangement and to thereby correct up to a predetermined maximum number of errors which are correctable; and
outputting (18,20) the information symbols;
characterised by
each of said first pointers indicating for its corresponding column either
(a) no error or the number of corrected errors is within a predetermined number or
(b) the number of corrected errors is over the predetermined number or errors cannot be corrected by the first error correction codes
storing the respective first pointers in memory means (13) having at least n₂ bits;
generating respective second pointers for each row indicating for that row which of the following conditions c, d or e applies:
(c) no error is detected or error correction is possible by the second error correction codes
(d) error correction cannot be executed by the second error correction codes but the first pointers are of high reliability for that row
(e) error correction cannot be executed by the second error correcting codes and the first pointers are of low reliability for that row
storing the respective second pointers in memory means (17) having at least 2k₁ bits; and
referring (19) to the stored first (13) and second (17) pointers to manifest an indication of the reliability of the respective information symbols in response to the status of the respective first and second pointers in the respective columns and rows corresponding to the respective information symbols.

2. An apparatus for decoding error correction-code in which respective first error correction codes of (n₁, k₁), wherein n₁ denotes the code length, are encoded for every k₁ information symbols arranged in respective columns of a two dimensional arrangement of (k₁ X k₂) and respective second error correction codes of (n₂, k₂), where n₂ denotes the code length, are encoded for every k₂ information symbols arranged in respective rows of the two dimensional arrangement, the apparatus comprising:
receiving means (11) for receiving at least the respective first error correction codes;
decoding means (12, 16, 14) connected to said receiving means (11) and for decoding the respective first error correction codes to thereby detect errors in the respective columns of the two dimensional arrangement and correct those errors which are correctable and for generating respective first pointers, subsequent to error correction as a result of the first error correction codes, decoding the second error correction codes for the respective rows of the two dimensional arrangement and to thereby correct up to a predetermined maximum number of errors which are correctable; and
output means (18, 20) connected to said decoding means (12, 16, 14) and for deriving the information symbols;
characterised in that each of said first pointers indicates for its corresponding columns either
(a) no error or the number of corrected errors is within a predetermined number or
(b) the number of corrected errors is over the predetermined number or errors cannot be corrected by the first error correction codes
first memory means (13) are connected to said decoding means (12) and have a capacity of at least n₂ bits for storing the respective first pointers;
said decoding means (12, 16, 14) generating respective second pointers for each row indicating for that row which of the following conditions, c, d or e applies:
(c) no error is detected or error correction is possible by the second error correction codes
(d) error correction cannot be executed by the second error correction codes but the first pointers are of high reliability for that row
(e) error correction cannot be executed by the second error correction codes and the first pointers are of low reliability for that row
second memory means (17) connected to said decoding means (16) and having a capacity of at least 2k₁ bits for storing the respective second pointers; and
means (19) connected to said first and second memory means (13, 17) and for manifesting an indication of the reliability of the respective information symbols in response to the status of the respective first and second pointers in the respective columns and rows corresponding to the respective information symbols.

3. An apparatus according to claim 2, characterised in that
said decoding means comprises first decoding means (12, 14) being connected to said receiving means (11) and for decoding the respective first error correction codes and for generating the respective first pointers and second decoding means (16, 14) being connected to said first decoding means (12, 14) for decoding the respective second error correction codes and for generating the respective second pointers;
said first memory means (13) are connected to said first decoding means (12);
said second memory means (17) are connected to said second decoding means (16, 14); and
said output means (18, 20) are connected to said second decoding means (16, 14).

4. A method for decoding error correction code according to claim 1 wherein the respective second error correction codes are decoded by implementing an erasure correction for each code series of the second error correction codes by employing the respective first pointers; and further wherein:
the step of second decoding includes a step of calculating error values of erasure symbols by an algebraic expression consisting of a first term to be a common value and a second term to be individually independent values with respect to the erasure error corrections of the respective second error correction codes and the step of calculating error values includes implementing a first calculation of the first term only once corresponding to each of the respective first pointers; storing the result of the first calculation of the first term; and implementing each of the calculations for obtaining error values corresponding to the respective second error correction codes by each of second calculations of the second term and by using the stored result of the first calculation.

5. An apparatus according to claim 2 to 3 for decoding error correction code wherein the decoding means implements an erasure correction for each code series of the respective second error correction codes by employing the respective first pointers; and said decoding means (12, 14, 16, 29, 33-37) calculates in said second decoding error values of erasure symbols by an algebraic expression consisting of a first term to be a common value and a second term to be individually independent values with respect to the erasure error corrections of the respective second error correction codes and said decoding means (12, 13, 16; 29, 33, 34, 35, 36, 37) implements a first calculation of the first term only once corresponding to each of the respective first pointers, stores the result of the first calculation of the first term and implements each of the calculations for obtaining error values corresponding to the respective second error correction codes by each of second calculations of the second term and by using the stored result of the first calculation.

6. An apparatus according to claim 5 wherein said apparatus further comprises store means for storing the result of the first calculation of the said first term and implements each of the calculations for obtaining error values corresponding to the respective second error correction codes by each of second calculations of the second term and by using the stored result of the first calculation.

7. Apparatus according to claim 2, 3, 5 or 6, for decoding a non-dualistic error correction code in which one of a plurality of syndromes is a result of an addition of a series of received symbols in (mod. 2) and by which errors of a plurality of symbols in the series of received symbols, can be corrected, wherein the decoding means (12, 16, 14; 28, 29, 33, 34, 35, 36, 37) further comprises input means (21, 22; 28), syndrome generation means (23; 36, 37) for generating the syndromes, error location and error value calculation means (24, 29, 36, 37) connected to said syndrome generation means (23; 36, 37) and for generating error locations and error values according to the syndromes, error correction means (25; 37) connected to said input means (21, 22; 28) and error location and error value calculation means (24; 29, 36, 37) and for correcting an erroneous symbol by adding the error value and output means (26, 27; 28) connected to said error correction means (25; 37),
said error location and error value calculation means (24; 29, 36, 37) including a syndrome register (29) for storing the syndromes, and exclusive-OR gate (31) connected to said syndrome register (29) and supplied with the syndrome and error values and for adding error values to the syndrome so as to generate an error value stored in said syndrome register (29) for correcting an erroneous symbol.

8. A method according to claim 1 or 4 further comprising the steps, for decoding and correcting Reed=Solomon code of:
solving the expression 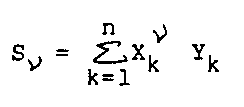 where,
ν = 0 to d - 2
n : Number of erasure
Xₖ : Location of kth element
S_{ν} : Syndrome
Yₖ : Magnitude of error in the erasure of kth element
d : Minimum distance of code
to obtain roots of the expression;
making erasure correction of errors encoded in the Reed=Solomon code in accordance with the roots, characterized in that; the roots are obtained by solving the expression 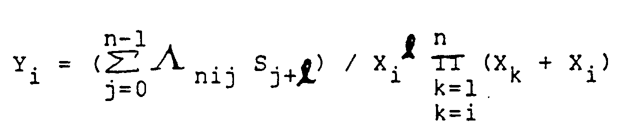 where
Λₙᵢⱼ : Coefficient of Z^{j} of 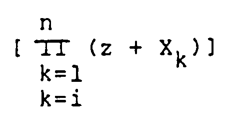
ℓ : Any integer more than or equal to 0 which satisfies ℓ < d - n - 1.

9. Apparatus according to claims 2, 3, 5, 6 or 7, for decoding and correcting erasure in Reed-Solomon code in accordance with the roots of 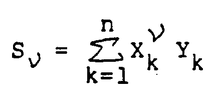 where,
ν = 0 to d - 2
n : Number of erasure
Xₖ : Location of kth element
S_{ν} : Syndrome
Yₖ : Magnitude of error in the erasure of kth element
d : Minimum distance of the code
wherein said decoding means (12, 14, 16; 28, 29, 33-37) further comprises
syndrome register means (29) for storing syndrome S_{ν}; and
operating logic means (37) for obtaining the roots Yᵢ by solving the expression: 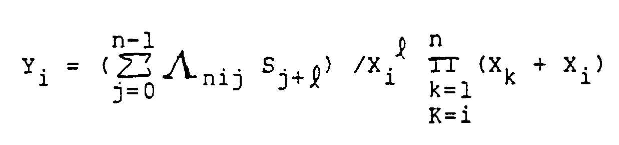 where
Λₙᵢⱼ : Coefficient of Z^{j} of 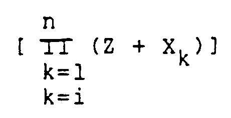
ℓ : Any integer more than or equal to 0 which satisfies ℓ ≦ d - n - 1
said operating logic means (37) including
register means (38) for storing syndrome S_{ν};
register means (39) for storing 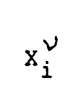 Yᵢ;
register means (40) for storing Xᵢ;
adder means (41) for adding S_{ν} and 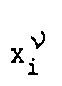 Yᵢ and for supplying said register means (38) and syndrome register means (29) with S_{ν} + 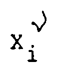 Yᵢ;
multiplyer means (42) for multiplying Xᵢ and 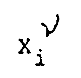 Yᵢ and for supplying said register means (39) with 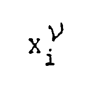 Yᵢ.

## Patentansprüche

1. Verfahren zum Decodieren eines Fehlerkorrekturcodes, bei welchem jeweils erste Korrekturcodes von (n₁, k₁), wobei n₁ die Codelänge bezeichnet, für alle k₁ Informationssymbole, die in jeweiligen Spalten einer zweidimensionalen Anordnung von (k₁ * k₂) angeordnet sind, codiert werden, und jeweils zweite Fehlerkorrekturcodes von (n₂, k₂), wobei n₂ die Codelänge bezeichnet, für alle k₂ Informationssysmbole, die in jeweiligen Zeilen der zweidimensionalen Anordnung angeordnet sind, codiert werden, wobei das Verfahren die Schritte aufweist:
Empfangen (11) mindestens der jeweiligen ersten Fehlerkorrekturcodes;
Decodieren (12, 16, 14) der ersten Fehlerkorrekturcodes, um dadurch Fehler in den jeweiligen Spalten der zweidimensionalen Anordnung festzustellen und jene Fehler zu korrigieren, die korrigierbar sind;
Erzeugen von jeweils ersten Zeigern im Anschluß an die Fehlerkorrektur als ein Ergebnis der ersten Fehlerkorrekturcodes;
Decodieren der zweiten Fehlerkorrekturcodes für die jeweiligen Zeilen der zweidimensionalen Anordnung und dabei Korrigieren bis zu einer vorgegebenen maximalen Anzahl von Fehlern, welche korrigierbar sind; und
Ausgeben (18, 20) der Informationssymbole; gekennzeichnet durch
Anzeigen der genannten ersten Zeiger für seine entsprechende Spalte entweder
(a) kein Fehler oder die Anzahl der korrigierten Fehler liegt innerhalb einer vorgegebenen Anzahl, oder
(b) die Anzahl der korrigierten Fehler liegt über der vorgegebenen Anzahl oder Fehler können durch die ersten Fehlerkorrekturcodes nicht korrigiert werden,
Speichern der jeweiligen Zeiger in Speichermitteln (13) mit mindestens n₂ Bits;
Erzeugen jeweiliger zweiter Zeiger für jede Zeile, die für diese Zeile anzeigen, welche der folgenden Bedingungen c, d oder e vorliegt:
(c) kein Fehler feststellbar oder Fehlerkorrektur ist mittels der zweiten Fehlerkorrekturcodes möglich,
(d) Fehlerkorrektur kann durch die zweiten Fehlerkorrekturcodes nicht ausgeführt werden, aber die ersten Zeiger sind für diese Zeile von hoher Zuverlässigkeit,
(e) Fehlerkorrektur kann durch die zweiten Fehlerkorrekturcodes nicht ausgeführt werden und die ersten Zeiger sind für diese Zeile von niedriger Zuverlässigkeit,
Speichern der jeweiligen zweiten Zeiger in Speichermitteln (17) mit mindestens 2k₁ Bits; und
Zuordnen (19) der gespeicherten ersten (13) und zweiten (17) Zeiger, um eine Anzeige der Zuverlässigkeit der jeweiligen Informationssymbole als Reaktion auf den Status der jeweiligen ersten und zweiten Zeiger in den jeweiligen Spalten und Reihen, entsprechend den jeweiligen Informationssymbolen zu manifestieren.

2. Vorrichtung zum Dekodieren eines Fehlerkorrekturcodes, bei welchem jeweils erste Korrekturcodes von (n₁, k₁), wobei n₁ die Codelänge bezeichnet, für alle k₁ Informationssymbole, die in jeweiligen Spalten einer zweidimensionalen Anordnung von (k₁ * k₂) angeordnet sind, codiert werden, und jeweils zweite Fehlerkorrekturcodes von (n₂, k₂), wobei n₂ die Codelänge bezeichnet, für alle k₂ Informationssysmbole, die in jeweiligen Zeilen der zweidimensionalen Anordnung angeordnet sind, codiert werden, wobei die Vorrichtung umfaßt:
Empfangsmittel (11) zum Empfang mindestens der jeweiligen ersten Korrekturfehlercodes;
Decodierungsmittel (12, 16, 14), die mit den genannten Empfangsmittel (11) verbunden sind und zum Dekodieren (12, 16, 14) der ersten Fehlerkorrekturcodes, um dadurch Fehler in den jeweiligen Spalten der zweidimensionalen Anordnung festzustellen und jene Fehler zu korrigieren, die korrigierbar sind, und zum Erzeugen von jeweils ersten Zeigern im Anschluß an die Fehlerkorrektur als ein Ergebnis der ersten Fehlerkorrekturcodes, zum Decodieren der zweiten Fehlerkorrekturcodes für die jeweiligen Zeilen der zweidimensionalen Anordnung dienen und dabei Fehler bis zu einer vorgegebenen maximalen Anzahl korrigieren, welche korrigierbar sind; und
Ausgabemittel (18, 20), die mit den genannten Decodierungsmitteln (12, 16, 14) verbunden sind und zum Herleiten der Informationssymbole dienen;
dadurch gekennzeichnet, daß daß jeder der genannten ersten Zeiger für seine entsprechende Spalte entweder anzeigt
(a) kein Fehler oder die Anzahl der korrigierten Fehler liegt innerhalb einer vorgegebenen Anzahl oder
(b) die Anzahl der korrigierten Fehler liegt über der vorgegebenen Anzahl oder Fehler können durch die ersten Fehlerkorrekturcodes nicht korrigiert werden,
daß erste Speichermittel (13) mit den genannten Decodierungsmitteln (12) verbunden sind und eine Kapazität von mindestens n₂ Bits zum Speichern der jeweiligen ersten Zeiger besitzen;
daß die genannten Decodierungsmittel (12, 16, 14) zum Erzeugen der jeweiligen zweiten Zeiger für jede Zeile für diese Zeile anzeigen, welche der folgenden Bedingungen c, d oder e vorliegt:
(c) kein Fehler feststellbar oder Fehlerkorrektur ist mittels der zweiten Fehlerkorrekturcodes möglich,
(d) Fehlerkorrektur kann durch die zweiten Fehlerkorrekturcodes nicht ausgeführt werden, aber die ersten Zeiger sind für diese Zeile von hoher Zuverlässigkeit,
(e) Fehlerkorrektur kann durch die zweiten Fehlerkorrekturcodes nicht ausgeführt werden und die ersten Zeiger sind für diese Zeile von niedriger Zuverlässigkeit,
daß zweite Speichermittel (17) mit den genannten Decodierungsmittel (16) verbunden sind und eine Kapazität von von mindestens 2k₁ Bits zum Speichern der jeweiligen zweiten Zeiger aufweisen; und
daß Mittel (19) mit den genannten ersten und zweiten Speichermittel (13, 17) verbunden sind, und zum Manifestieren einer Anzeige der Zuverlässigkeit der jeweiligen Informationssymbole als Reaktion auf den Status der jeweiligen ersten und zweiten Zeiger in den jeweiligen Spalten und Reihen, entsprechend den jeweiligen Informationssymbolen.

3. Vorrichtung nach Anspruch 2, dadurch gekennzeichnt,
daß die genannten Decodierungsmittel erste Decodierungsmittel (12, 14), die mit den genannten Empfangsmitteln (11) verbunden sind, und zum Decodieren der jeweiligen ersten Fehlerkorrekturcodes und zum Erzeugen der jeweiligen ersten Zeiger dienen, und zweite Decodierungsmittel (16, 14) aufweisen, die mit den genannten ersten Decodierungsmittel (12, 14) verbunden sind, zum Decodieren der jeweiligen zweiten Fehlerkorrekturcodes und zum Erzeugen der jeweiligen zweiten Zeiger;
daß die genannten ersten Speichermittel (13) mit den genannten ersten Decodierungsmitteln (12) verbunden sind;
daß die genannten zweiten Speichermittel (17) mit den genannten zweiten Decodierungsmittel (16, 14) verbunden sind; und
daß die genannten Ausgabemittel (18, 20) mit den genannten zweiten Decodierungsmittel (16, 14) verbunden sind.

4. Verfahren zum Decodieren eines Fehlerkorrekturcodes nach Anspruch 1, bei dem die jeweiligen zweiten Fehlerkorrekturcodes mittels Durchführung einer Löschkorrektur für jede Codefolge der zweiten Fehlerkorrekturcodes durch Verwendung der jeweiligen ersten Zeiger decodiert werden; und bei dem weiterhin
der Schritt des zweiten Decodierens einen Schritt des Berechnens der Fehlerwerte von Löschsymbolen mittels eines algebraischen Ausdrucks enthält, der aus einem ersten Term, welcher ein allgemeiner Wert ist, und einem zweiten Term, welcher aus individuellen unabhängigen Werten bezüglich der Löschfehlerkorrekturen der jeweiligen zweiten Fehlerkorrekturcodes besteht, und bei dem der Schritt des Berechnens der Fehlerwerte die Ausführung einer ersten Berechnung des ersten Terms nur einmal entsprechend jedem der jeweiligen ersten Zeiger enthält; Speichern des Ergebnisses der ersten Berechnung des ersten Terms; und Ausführen jeder der Berechnungen zum Erhalten von Fehlerwerten entsprechend der jeweiligen zweiten Fehlerkorrekturcodes durch jede der zweiten Berechnungen des zweiten Terms und durch Verwendung des gespeicherten Ergebnisses der ersten Berechnung.

5. Vorrichtung nach Anspruch 2 bis 3 zum Decodieren eines Fehlerkorrekturcodes, bei welcher die Decodierungsmittel einen Löschkorrektur für jede Codefolgen der jeweiligen zweiten Fehlerkorrekturcodes durch Anwenden der jeweiligen ersten Zeiger ausführen; und bei der die genannten Decodierungsmittel (12, 14, 16, 29, 33-37) in den genannten zweiten Decodierungsmitteln die Fehlerwerte der Löschsymbole mittels eines algebraischen Ausdrucks berechnen, der aus einem ersten Term, welcher ein allgemeiner Wert ist, und einem zweiten Term, welcher aus individuellen unabhängigen Werten bezüglich der Löschfehlerkorrekturen der jeweiligen zweiten Fehlerkorrekturcodes besteht, und bei welcher die genannten Decodierungsmittel (12, 13, 16; 29, 33, 34, 36, 37) eine erste Berechnung des ersten Terms nur einmal entsprechend jedem der jeweiligen ersten Zeiger ausführen, das Ergebnis der ersten Berechnung des ersten Terms speichern und jede der Berechnungen zum Erhalten von Fehlerverten entsprechend der jeweiligen zweiten Fehlerkorrekturcodes durch jede der zweiten Berechnungen des zweiten Terms und durch Verwendung des gespeicherten Ergebnisses der ersten Berechnung ausführen.

6. Vorrichtung nach Anspruch 5, bei welcher die genannte Vorrichtung weiterhin Speichermittel zum Speichern des Ergebnisses der ersten Berechnung des genannten ersten Terms aufweist, und jede der Berechnungen zum Erhalt von Fehlerwerten entsprechend den jeweiligen zweiten Fehlerkorrekturcodes durch jede der zweiten Berechnungen des zweiten Terms und durch Verwendung des gespeicherten Ergebnisses der ersten Berechnung ausführt.

7. Vorrichtung nach Anspruch 2, 3, 5 oder 6 zum Decodieren eines nicht-dualen Fehlerkorrekturcodes, bei welchem eines einer Vielzahl von Syndrome ein Ergebnis einer Addition einer Folge von empfangenen Symbolen in (mod. 2) ist und durch welche Fehler einer Vielzahl von Symbolen in den Folgen von empfangenen Symbolen korrigiert werden können, in welcher die Decodierungsmittel (12, 15, 14; 28, 29, 33, 34, 35, 36, 37) weiterhin Eingabemittel (21, 22; 28), Syndromerzeugungsmittel (23; 36, 37) zum Erzeugen der Syndrome, Fehlerlokalisierungs- und Fehlerwertberechnungsmittel (24, 29, 36, 37), die mit den genannten Syndromerzeugungsmittel (23; 36, 37) verbunden sind und zum Erzeugen von Fehlerlokalisierungen und Fehlerwerten entsprechend der Syndrome dienen, Fehlerkorrekturmittel (25; 37), die mit den genannten Eingabemittel (21, 22; 28) und Fehlerlokalisierungs- und Fehlerwertberechnungsmittel (24; 29, 36, 37) verbunden sind, und zum Korrigieren eines fehlerhaften Symbols durch Addieren des Fehlerwertes dienen, und Ausgabemittel (26, 27; 28) enthalten, die mit den genannten Fehlerkorrekturmittel (25; 37) verbunden sind,
wobei die genannten Fehlerlokalisierungs- und Fehlerwertberechnungsmittel (24; 29, 36, 37) ein Syndromregister zum Speichern der Syndrome und ein Exklusiv-ODER-Gatter (31) enthalten, das mit dem genannten Register (29) verbunden ist und mit den Syndrom- und Fehlerwerten gespeist wird, und zum Addieren der Fehlerwerte zu den Syndromen dient, um einen in dem genannten Syndromregister (29) gespeicherten Fehlerwert für die Korrektur eines fehlerhaften Symbols zu erzeugen.

8. Verfahren nach Anspruch 1 oder 4, welches weiterhin die Schritte zum Decodieren und Korrigieren eines Reed-Solomon-Codes aufweist:
Lösen der Gleichung 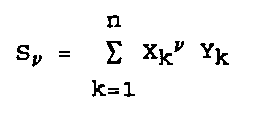 wobei
ν = 0 bis d-2
n : Nummer der Löschung
Xₖ : Lage des k-ten Elements
S_{ν} : Syndrom
Yₖ : Größe des Fehlers in der Löschung des k-ten Elements
d : Minimalabstand des Codes
zum Erhalten von Wurzeln der Gleichung;
Durchführen einer Löschkorrektur von in dem Reed-Solomon-Code codierten Fehlern in Übereinstimmung mit den Wurzeln, dadurch gekennzeichnet, daß die Wurzeln durch Lösung der Gleichung 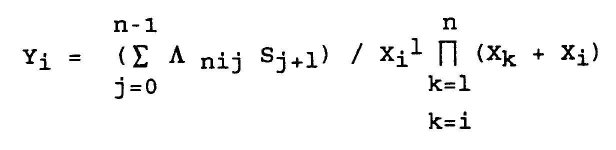 erhalten werden, wobei
Λₙᵢⱼ : Koeffizient von Z^{j} von 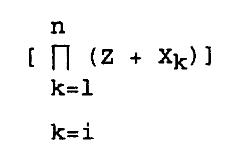
l : Jede ganze Zahl größer oder gleich 0, welche l < d - n -1 erfüllt.

9. Vorrichtung nach den Ansprüchen 2, 3, 5, 6 oder 7 zum Decodieren und Korrigieren einer Löschung in einem Reed-Solomon-Code in Übereinstimmung mit den Wurzeln von 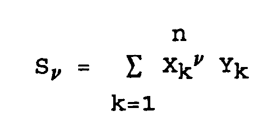 wobei
ν = 0 bis d-2
n : Nummer der Löschung
Xₖ : Lage des k-ten Elements
S_{ν} : Syndrom
Yₖ : Größe des Fehlers in der Löschung des k-ten Elements
d : Minimalabstand des Codes
bei welcher die genannten Decodierungsmittel weiterhin Syndromregistermittel (29) zum Speichern eines Syndroms S_{ν} und wirksame Logikmittel (37) zum Erhalten der Wurzel Yᵢ durch Lösen der Gleichung: 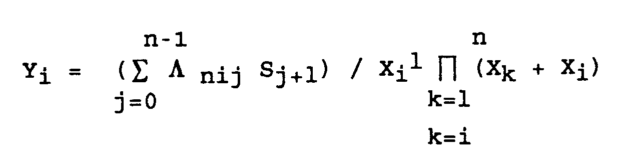 erhalten werden, wobei
Λₙᵢⱼ : Koeffizient von Z^{j} von 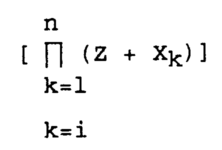
l : Jede ganze Zahl größer oder gleich 0, welche l < d - n -1 erfüllt,
wobei die wirksamen Logikmittel (37) enthalten
Registermittel (38) zum Speichern eines Syndroms S_{ν};
Registermittel zum Speichern von 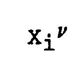 Yᵢ;
Registermittel (40) zum Speicher von Xᵢ;
Additionsmittel (41) zum Addieren von S_{ν} und 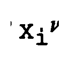 Yᵢ und zum Speisen der genannten Registermittel (38) und Syndromregistermittel (29) mit S_{ν} + 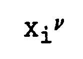 Yᵢ;
Multiplikationsmittel (42) zum Multiplizieren von Xᵢ und 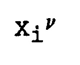 Yᵢ und zum Speisen der genannten Registermittel (39) mit Xᵢ^{ν} Yᵢ.

## Revendications

1. Procédé pour décoder un code de correction d'erreurs dans lequel des premiers codes de correction d'erreurs respectifs de (n₁, k₁), où n₁ indique la longueur du code, sont codés pour chaque groupe de k₁ symboles d'information disposés dans les colonnes respectives d'une disposition à deux dimensions de (k₁ x k₂) et des seconds codes de correction d'erreurs respectifs de (n₂, k₂), où n₂ indique la longueur du code, sont codés pour chaque groupe de k₂ symboles d'information disposés sur les lignes respectives de la disposition à deux dimensions, le procédé comprenant les étapes qui consistent à :
recevoir (11) au moins les premiers codes de correction d'erreurs respectifs ;
décoder (12, 16, 14) les premiers codes de correction d'erreurs pour détecter ainsi des erreurs dans les colonnes respectives de la disposition à deux dimensions et corriger les erreurs qui sont corrigibles ;
générer des premiers pointeurs respectifs à la suite d'une correction d'erreurs résultant des premiers codes de correction d'erreurs ;
décoder les seconds codes de correction d'erreurs pour les lignes respectives de la disposition à deux dimensions et pour corriger ainsi jusqu'à un nombre maximal prédéterminé d'erreurs qui sont corrigibles ; et à
sortir (18, 20) les symboles d'information ; caractérisé par
chacun desdits premiers pointeurs indiquant, pour sa colonne correspondante,
(a) s'il n'y a aucune erreur ou si le nombre d'erreurs corrigées est limité à un nombre prédéterminé, ou
(b) si le nombre d'erreurs corrigées dépasse le nombre prédéterminé ou si des erreurs ne peuvent pas être corrigées par les premiers codes de correction d'erreurs ;
la mémorisation des premiers pointeurs respectifs dans un moyen de mémoire (13) comportant au moins n₂ bits ;
la génération de seconds pointeurs respectifs pour chaque ligne indiquant, pour cette ligne, laquelle des conditions suivantes c, d ou e s'applique :
(c) aucune erreur n'est détectée ou une correction d'erreurs est possible par les seconds codes de correction d'erreurs ;
(d) une correction d'erreurs ne peut pas être exécutée par les seconds codes de correction d'erreurs mais les premiers pointeurs ont une fiabilité élevée pour cette ligne ;
(e) une correction d'erreurs ne peut pas être exécutée par les seconds codes de correction d'erreurs et les premiers pointeurs ont une faible fiabilité pour cette ligne ;
la mémorisation des seconds pointeurs respectifs dans un moyen de mémoire (17) comportant au moins 2k₁ bits ; et
la référence (19) aux premiers (13) et seconds (17) pointeurs mémorisés pour donner une indication de la fiabilité des symboles d'information respectifs en réponse à l'état des premiers et seconds pointeurs respectifs dans les colonnes et lignes respectives correspondant aux symboles d'information respectifs.

2. Dispositif pour décoder un code de correction d'erreurs dans lequel des premiers codes de correction d'erreurs respectifs de (n₁, k₁), où n¹ indique la longueur du code, sont codés pour chaque groupe de k₁ symboles d'information disposés dans les colonnes respectives d'une disposition à deux dimensions de (k₁ x k₂) et des seconds codes de correction d'erreurs respectifs de (n₂, k₂), où n₂ indique la longueur du code, sont codés pour chaque groupe de k₂ symboles d'information disposés sur les lignes respectives de la disposition à deux dimensions, le dispositif comprenant :
un moyen récepteur (11) pour recevoir au moins les premiers codes de correction d'erreurs respectifs ;
un moyen décodeur (12, 16, 14), connecté audit moyen récepteur (11), pour décoder les premiers codes de correction d'erreurs respectifs afin de détecter ainsi les erreurs dans les colonnes respectives de la disposition à deux dimensions et corriger les erreurs qui sont corrigibles et pour générer des premiers pointeurs respectifs, à la suite d'une correction d'erreurs résultant des premiers codes de correction d'erreurs, et décoder les seconds codes de correction d'erreurs pour les lignes respectives de la disposition à deux dimensions afin de corriger ainsi jusqu'à un nombre maximal prédéterminé d'erreurs qui sont corrigibles ; et
un moyen de sortie (18, 20), connecté audit moyen décodeur (12, 16, 14), pour dériver les symboles d'information ;
caractérisé en ce que chacun desdits premiers pointeurs indique, pour sa colonne correspondante :
(a) s'il n'y a aucune erreur ou si le nombre d'erreurs corrigées est limité à un nombre prédéterminé, ou
(b) si le nombre d'erreurs corrigées dépasse le nombre prédéterminé ou si des erreurs ne peuvent pas être corrigées par les premiers codes de correction d'erreurs ;
un premier moyen de mémoire (13) est connecté audit moyen décodeur (12) et a une capacité d'au moins n₂ bits pour mémoriser les premiers pointeurs respectifs ;
ledit moyen décodeur (12, 16, 14) générant des seconds pointeurs respectifs pour chaque ligne indiquant, pour cette ligne, laquelle des conditions suivantes c, d ou e s'applique :
(c) si aucune erreur n'est détectée ou si une correction d'erreurs est possible par les seconds codes de correction d'erreurs ;
(d) une correction d'erreurs ne peut pas être exécutée par les seconds codes de correction d'erreurs mais les premiers pointeurs ont une fiabilité élevée pour cette ligne ;
(e) une correction d'erreurs ne peut pas être exécutée par les seconds codes de correction d'erreurs et les premiers pointeurs ont une faible fiabilité pour cette ligne ;
un second moyen de mémoire (17) connecté audit moyen décodeur (16) et ayant une capacité d'au moins 2k₁ bits pour mémoriser les seconds pointeurs respectifs ; et
un moyen (19),connecté auxdits premier et second moyens de mémoire (13, 17) , pour donner une indication de la fiabilité des symboles d'information respectifs en réponse à l'état des premiers et seconds pointeurs dans les colonnes et lignes respectives correspondant aux symboles d'information respectifs.

3. Dispositif selon la revendication 2, caractérisé en ce que :
ledit moyen décodeur comprend un premier moyen décodeur (12, 14), connecté audit moyen récepteur (11), pour décoder les premiers codes de correction d'erreurs et générer les premiers pointeurs respectifs, et un second moyen décodeur (16, 14), connecté audit premier moyen décodeur (12, 14), pour décoder les seconds codes de correction d'erreurs respectifs et générer les seconds pointeurs respectifs ;
ledit premier moyen de mémoire (13) est connecté audit premier moyen décodeur (12) ;
ledit second moyen de mémoire (17) est connecté audit second moyen décodeur (16, 14) ; et
ledit moyen de sortie (18, 20) est connecté audit second moyen décodeur (16, 14).

4. Procédé pour décoder un code de correction d'erreurs selon la revendication 1, dans lequel les seconds codes de correction d'erreurs respectifs sont décodés par la réalisation d'une correction d'effacement pour chaque série de codes des seconds codes de correction d'erreurs par la mise en oeuvre des premiers pointeurs respectifs ; et dans lequel en outre :
l'étape du second décodage comprend une étape qui consiste à calculer des valeurs d'erreur d'effacement de symboles par une expression algébrique constituée d'un premier terme en tant que valeur commune et d'un second terme en tant que valeurs individuellement indépendantes par rapport aux corrections d'erreurs d'effacement des seconds codes de correction d'erreurs respectifs, et l'étape de calcul des valeurs d'erreur comprend l'exécution d'un premier calcul du premier terme correspondant une seule fois à chacun des premiers pointeurs respectifs ; la mémorisation du résultat du premier calcul du premier terme ; et la mise en oeuvre de chacun des calculs pour obtenir des valeurs d'erreur correspondant aux seconds codes de correction d'erreurs respectifs par chacun des seconds calculs du second terme et par l'utilisation du résultat du premier calcul mémorisé.

5. Dispositif, selon l'une quelconque des revendications 2 et 3, pour décoder un code de correction d'erreurs, dans lequel le moyen décodeur réalise une correction d'effacement pour chaque série de codes des seconds codes de correction d'erreurs respectifs en mettant en oeuvre les premiers pointeurs respectifs ; et ledit moyen décodeur (12, 14, 16; 29, 33-37) calcule dans ledit second décodage les valeurs d'erreur d'effacement de symboles par une expression algébrique constituée d'un premier terme en tant que valeur commune et d'un second terme en tant que valeurs individuellement indépendantes par rapport aux corrections d'erreurs d'effacement des seconds codes de correction d'erreurs respectifs, et ledit moyen décodeur (12, 13, 16; 29, 33, 34, 35, 36, 37) exécute un premier calcul du premier terme correspondant une seule fois à chacun des premiers pointeurs respectifs, mémorise le résultat du premier calcul du premier terme et exécute chacun des calculs pour obtenir des valeurs d'erreur correspondant aux seconds codes de correction d'erreurs respectifs par chacun de seconds calculs du second terme et en utilisant le résultat du premier calcul mémorisé.

6. Dispositif selon la revendication 5, dans lequel ce dispositif comprend en outre un moyen de mémoire pour mémoriser le résultat du premier calcul dudit premier terme et exécute chacun des calculs pour obtenir des valeurs d'erreur correspondant aux seconds codes de correction d'erreurs respectifs par chacun des seconds calculs du second terme et en utilisant le résultat du premier calcul mémorisé.

7. Dispositif, selon l'une quelconque des revendications 2, 3, 5 et 6, pour décoder un code de correction d'erreurs non dualistes dans lequel un d'une pluralité de syndromes est le résultat d'une addition d'une série de symboles reçus en modulo 2 et par lequel des erreurs d'une pluralité de symboles dans la série des symboles reçus peuvent être corrigées, dans lequel le moyen décodeur (12, 16, 14; 28, 29, 33, 34, 35, 36, 37) comprend en outre un moyen d'entrée (21, 22; 28), un moyen générateur de syndromes (23; 36, 37) pour générer les syndromes, un moyen de calcul d'emplacements d'erreur et de valeurs d'erreur (24, 29, 36, 37), connecté audit moyen générateur de syndromes (23; 36, 37), pour générer des emplacements d'erreur et des valeurs d'erreur selon les syndromes, un moyen de correction d'erreurs (25; 37), connecté audit moyen d'entrée (22; 22, 28) et audit moyen de calcul d'emplacements d'erreur et de valeurs d'erreur (24; 29, 36, 37), pour corriger un symbole erroné en ajoutant la valeur d'erreur, et un moyen de sortie (26, 27; 28) connecté audit moyen de correction d'erreurs (25; 37),
ledit moyen de calcul d'emplacements d'erreur et de valeurs d'erreur (24; 29, 36, 37) incluant un registre de syndrome (29) pour mémoriser les syndromes, et une porte OU-exclusif (31), connectée audit registre de syndrome (29) et recevant le syndrome et les valeurs d'erreur, pour ajouter les valeurs d'erreur au syndrome de manière à générer une valeur d'erreur mémorisée dans ledit registre de syndrome (29) pour la correction d'un symbole erroné.

8. Procédé selon l'une quelconque des revendications 1 et 4, comprenant en outre les étapes qui consistent, pour décoder et corriger un code de Reed-Solomon, à :
résoudre l'expression 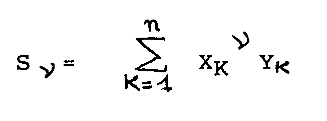 où,
ν = 0 à d-2
n : Numéro de l'effacement
X_{K} : Emplacement du kième élément
S_{ν} : Syndrome
Y_{K} : Grandeur de l'erreur dans l'effacement du k^{ième} élément
d : Distance minimale du code pour obtenir les racines de l'expression ;
exécuter une correction d'erreurs d'effacement codées dans le code de Reed-Solomon selon les racines, caractérisé en ce que :
les racines sont obtenues en résolvant l'expression 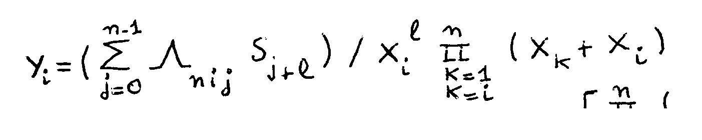 où
Λₙᵢⱼ : Coefficient de Z^{j} de 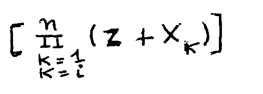
ℓ : Tout entier supérieur ou égal à 0 qui satisfait ℓ d - n - 1.

9. Dispositif, selon l'une quelconque des revendications 2, 3, 5, 6 et 7, pour décoder et corriger un effacement dans un code de Reed-Solomon selon les racines de 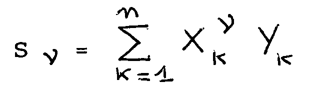 où
ν = 0 à d-2
n : Numéro d'effacement
Xₖ : Emplacement du k^{ième} élément
S_{ν} : Syndrome
Yₖ : Grandeur de l'erreur dans l'effacement du k^{ième} élément
d : Distance minimale du code
où le dit moyen décodeur (12, 14, 16; 28, 29, 33-37) comprend en outre :
un moyen de registre de syndrome (29) pour mémoriser un syndrome S_{ν} ; et
un moyen logique de traitement (37) pour obtenir les racines Yᵢ par la résolution de l'expression : 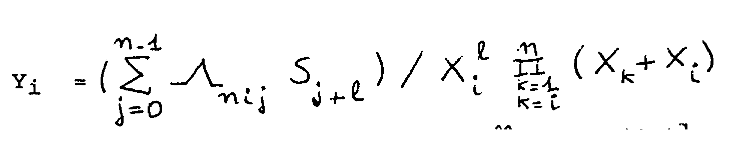 où
Λₙᵢⱼ : Coefficient de Z^{j} de 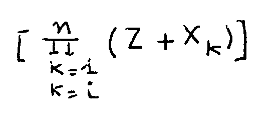
ℓ : Tout entier supérieur ou égal à 0 qui satisfait l ≦ d-n-1
ledit moyen logique de traitement (37) incluant :
un moyen de registre (38) pour mémoriser un syndrome S_{ν} ;
un moyen de registre (39) pour mémoriser 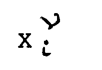 Yᵢ ;
un moyen de registre (40) pour mémoriser Xᵢ ;
un moyen additionneur(41) pour additionner S_{ν} et Xᵢ^{ν}Yᵢ et pour fournir audit moyen de registre (38) et audit moyen de registre de syndrome (29) la valeur de (Sν + 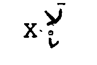 Yi) ;
un moyen multiplicateur (42) pour multiplier Xᵢ et 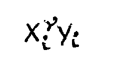 ,et fournir audit moyen de registre (29) la valeur de 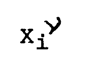 Yᵢ.
